# EUROPEAN PATENT APPLICATION

(11) **EP 4 439 667 A1**
(43) Date of publication of application: **02.10.2024**
(21) Application number: 23220533.6
(22) Date of filing: 28.12.2023
(51) Int. Cl.: H01L 27/02, H01L 29/06, H01L 29/861

(54) **SEMICONDUCTOR DEVICE INCLUDING ESD DIODE AND METHOD FOR MANUFACTURING THE SAME**

(30) Priority: 27.03.2023 KR 20230039849
(71) Applicant: Samsung Electronics Co., Ltd., Suwon-si, Gyeonggi-do 16677 (KR)
(72) Inventor: SEO, Jungmin, 16677 Suwon-si, Gyeonggi-do (KR); SUNG, Sukkang, 16677 Suwon-si, Gyeonggi-do (KR); LEE, Cheonan, 16677 Suwon-si, Gyeonggi-do (KR); LEE, Sangeun, 16677 Suwon-si, Gyeonggi-do (KR); LEE, Chanho, 16677 Suwon-si, Gyeonggi-do (KR)
(74) Representative: Kuhnen & Wacker Patent- und Rechtsanwaltsbüro PartG mbB

(57) **Abstract**

A semiconductor device according to an embodiment of the present inventive concept comprises: a first power supply pad (201) configured to receive a first power supply voltage (VDD); a second power supply pad (202) configured to receive a second power supply voltage (VSS), the second power supply voltage (VSS) having a level lower than a level of the first power supply voltage (VDD); a signal pad (203) configured to exchange a signal; and a first electrostatic discharge (ESD) diode comprising a first impurity region (310) doped with impurities of a first conductivity type and connected to the first power supply pad (201), and a second impurity region (320) doped with impurities of a second conductivity type different from the first conductivity type and connected to the signal pad (203), wherein a lower surface of at least one of the first impurity region (310) and the second impurity region (320) has an uneven structure.

## Description

### BACKGROUND

The present inventive concept relates to a semiconductor device including an electrostatic discharge (ESD) diode.

A semiconductor device includes a plurality of semiconductor elements, and some of the plurality of semiconductor elements may comprise a receiving circuit and a transmitting circuit for exchanging a signal with another external semiconductor device. The receiving circuit and the transmitting circuit may be connected to a pad for exchanging a signal. In order to protect the semiconductor elements from electrostatic discharge (ESD) which may flow thereinto from the outside of the semiconductor device through the pad, the pad connected to the receiving circuit and the transmitting circuit may be connected to an ESD diode. The ESD diode may have a current drivability above a certain level in order to provide a path for a current caused by static electricity.

### SUMMARY

An object of an aspect of the present inventive concept is to provide a semiconductor device with an improved degree of integration and enhanced performance, by forming a lower surface of at least one of impurity regions included on an electrostatic discharge (ESD) diode to have an uneven structure so as to realize the ESD diode having a relatively small area as well as high current drivability.

According to an aspect of the present inventive concept, a semiconductor device according to an embodiment of the present inventive concept comprises: a first power supply pad configured to receive a first power supply voltage; a second power supply pad configured to receive a second power supply voltage, the second power supply voltage having a level lower than a level of the first power supply voltage; a signal pad configured to exchange a signal; and a first electrostatic discharge (ESD) diode comprising a first impurity region doped with impurities of a first conductivity type and connected to the first power supply pad, and a second impurity region doped with impurities of a second conductivity type different from the first conductivity type and connected to the signal pad, wherein a lower surface of at least one of the first impurity region and the second impurity region has an uneven structure.

According to an aspect of the present inventive concept, a semiconductor device, comprises: a first ESD diode connected between a first power supply pad configured to receive a first power supply voltage and a signal pad; and a second ESD diode connected between a second power supply pad configured to receive a second power supply voltage and the signal pad, the second power supply voltage having a level lower than a level of the first power supply voltage, wherein the first ESD diode comprises a first impurity region doped with N-type impurities and a second impurity region doped with P-type impurities, the second ESD diode comprises a third impurity region doped with N-type impurities and a fourth impurity region doped with P-type impurities, and the first to fourth impurity regions are formed in a well region of a substrate, and a lower surface of each of the first impurity region and the third impurity region has an uneven structure.

According to an aspect of the present inventive concept, a semiconductor device comprises: a cell region in which a plurality of memory cells are disposed in a first direction, and a second direction and a third direction, wherein the first and second directions are parallel to an upper surface of a substrate and intersect each other, and the third direction is perpendicular to the upper surface of the substrate; a peripheral circuit region in which peripheral circuits configured to control the plurality of memory cells are disposed; and a plurality of pads connected to the peripheral circuits, wherein the peripheral circuit region comprises an ESD diode connected to at least one signal pad among the plurality of pads, the signal pad being configured to exchange a signal with external device, the ESD diode comprises a first impurity region doped with N-type impurities and a second impurity region doped with P-type impurities, at least one of the first impurity region and the second impurity region comprises a plurality of first regions having a first thickness, and a plurality of second regions having a second thickness in the third direction less than the first thickness, and the plurality of first regions and the plurality of second regions are disposed to alternate between a first region and a second region in at least one of the first direction and the second direction.

According to another aspect of the invention, a method of manufacturing a semiconductor device includes: providing a substrate having a first well region at an upper surface of the substrate, wherein the first well region includes an isolation layer dividing the first well region into a first region for forming a first impurity region and a second region for forming a second impurity region; forming a mask layer on the upper surface of the substrate to cover the first well region with portions of the first region exposed; performing a first doping process to implant impurities of a first conductivity type in the portion of the first region exposed by the first mask layer to form the first impurity region, wherein the first impurity region includes areas having a greater thickness below the portion of the first region exposed by the first mask layer that areas below a remainder of the first region; removing the first mask layer; forming a second mask layer on the upper surface of the substrate to cover the first well region with portions of the second region exposed; performing a second doping process to implant impurity of a second conductivity type in the portion of the second region exposed by the second mask layer to form the second impurity region; and removing the second mask layer.

The various beneficial advantages and effects of the present inventive concept are not limited to the above, and will be more easily understood in the process of describing specific embodiments of the present inventive concept.

### BRIEF DESCRIPTION OF DRAWINGS

The above and other aspects, features, and advantages of the present inventive concept will be more clearly understood from the following detailed description, taken in conjunction with the accompanying drawings, in which:
FIG. 1 is a drawing schematically illustrating a system including semiconductor devices according to an embodiment of the present inventive concept;
FIG. 2 is a block diagram schematically illustrating a semiconductor device according to an embodiment of the present inventive concept;
FIG. 3 is a drawing schematically illustrating a semiconductor device according to an embodiment of the present inventive concept;
FIGS. 4 to 7 are drawings schematically illustrating an electrostatic discharge (ESD) diode included in a semiconductor device according to an embodiment of the present inventive concept;
FIGS. 8 to 11 are drawings schematically illustrating an ESD diode included in a semiconductor device according to an embodiment of the present inventive concept;
FIGS. 12 to 16 are drawings provided for describing a manufacturing process of an ESD diode included in a semiconductor device according to an embodiment of the present inventive concept;
FIGS. 17 to 21 are drawings provided for describing a manufacturing process of an ESD diode included in a semiconductor device according to an embodiment of the present inventive concept; and
FIGS. 22 to 23 are drawings schematically illustrating a semiconductor device according to an embodiment of the present inventive concept.

### DETAILED DESCRIPTION

Hereinafter, example embodiments of the present inventive concept will be described with reference to the accompanying drawings.

The various pads described herein may be connected to internal circuitry within the device to which they are connected, and may transmit signals and/or supply voltages to and/or from the device to which they are attached. For example, substrate pads disposed on the package substrate may connect to rerouting and other electrical lines disposed within the package substrate, and the pads disposed on the semiconductor chips may connect to an integrated circuit of on one or more of the semiconductor chips. The various pads described herein may generally have a planar surface at a location for connecting to a terminal for external communications outside of the device to which the pads are connected. The pads may be formed of a conductive material, such as a metal, for example.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

As used herein, components described as being "electrically connected" are configured such that an electrical signal can be transferred from one component to the other (although such electrical signal may be attenuated in strength as it is transferred and may be selectively transferred). Moreover, components that are "directly electrically connected" share a common electrical node through electrical connections by one or more conductors, such as, for example, wires, pads, internal electrical lines, through vias, etc. As such, directly electrically connected components do not include components electrically connected through active elements, such as transistors or diodes.

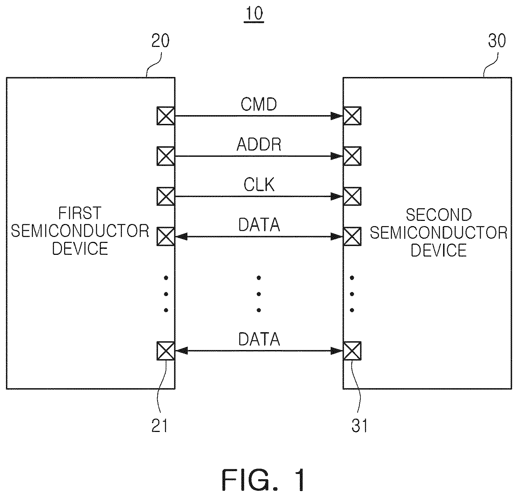

FIG. 1 is a drawing schematically illustrating a system including semiconductor devices according to an embodiment of the present inventive concept.

Referring to FIG. 1, a system 10 according to an embodiment of the present inventive concept may include a first semiconductor device 20 and a second semiconductor device 30. The first semiconductor device 20 and the second semiconductor device 30 may operate while exchanging a signal with each other. In the embodiment shown in FIG. 1, the first semiconductor device 20 may operate as a memory controller, and the second semiconductor device 30 may operate as a memory device configured to store data.

The first semiconductor device 20 may include a plurality of first pads 21, the second semiconductor device 30 may include a plurality of second pads 31, and respective pads of the plurality of first pads 21 and the plurality of second pads 31 may be electrically connected to each other so as to provide a signal transmission path. For example, the first semiconductor device 20 may transmit a command signal CMD, an address signal ADDR, a clock signal CLK, and/or the like to the second semiconductor device 30 by way of a respective first pad 21 and a respective second pad 31.

The second semiconductor device 30 may operate in response to the command signal CMD, the address signal ADDR, the clock signal CLK, and/or the like. The second semiconductor device 30 may store data contained in a data signal DATA received from the first semiconductor device 20 or transmit a data signal DATA generated by reading the stored data to the first semiconductor device 20.

The plurality of first pads 21 and the plurality of second pads 31 may be exposed to the outside (e.g., externally) and connected to a wiring pattern, a wire, and/or the like of a package substrate included in the system 10. If static electricity is generated in the surrounding environment while the plurality of second pads 31 are exposed to the outside, a large current may flow through at least one of the plurality of second pads 31. If the current flows into an internal circuit of the second semiconductor device 30, the second semiconductor device 30 may be damaged.

In order to prevent such a problem caused by static electricity, an electrostatic discharge (ESD) diode may be connected to at least one of the plurality of second pads 31. The ESD diode may include a first impurity region and a second impurity region formed on a semiconductor substrate, and the first impurity region and the second impurity region may be doped with impurities of different conductivity types. Each of the first impurity region and the second impurity region may be connected to at least one of the plurality of second pads 31 through metal wiring formed of a conductive material such as a metal, etc.

By connecting the ESD diode, a discharge path for a current flowing into the plurality of second pads 31 caused by static electricity may be provided, and damage to elements included in the second semiconductor device 30 may be prevented therefrom. In order for the ESD diode to provide a path for a current caused by static electricity, the ESD diode may be formed to have a high current drivability. For example, in order to increase the current drivability of the ESD diode, the first impurity region may be disposed to surround the second impurity region, and two or more second impurity regions, separated from each other, may be formed.

However, if the two or more second impurity regions separated from each other are included in one ESD diode, an area required to form the ESD diode may increase, and the degree of integration may decrease as a result. Furthermore, since a metal line must be connected to each of the two or more second impurity regions, the number of metal lines connected to the first impurity region and the second impurity region may increase, thereby increasing capacitance of the ESD diode. The capacitance of the ESD diode increases an input/output capacitance of the second pad 31 to which the ESD diode is connected, and therefore, the integrity of a signal output or received through the second pad 31 may deteriorate.

In an embodiment of the present inventive concept, an ESD diode may be realized with a first impurity region and a second impurity region formed in a limited (reduced) area to improve the degree of integration, and at the same time, the capacitance of the ESD diode may be reduced so as to increase the integrity of a signal input to/output from the pad to which the ESD diode is connected. According to an embodiment of the present inventive concept, a lower surface of each of the first impurity region and the second impurity region may have an uneven structure. However, depending on the type of the pad to which the ESD diode is connected, only one of the first impurity region and the second impurity region may have a lower surface having an uneven structure.

An uneven structure may refer to a surface or interface between elements that is manufactured to have variations in structure that deviate greater than uncontrolled deviations that may occur during a manufacturing process. For example, a flat surface that does not have an uneven structure may have surface irregularities such as pits, waves, protrusions, or other deviations from the plane of the flat surface that occur as part of a manufacturing process, whereas a surface having an uneven structure may have variations that extend from, or that are recessed into the surface an amount greater than the depth of a pit or the height of a protrusion that occurs as part of the manufacturing process. Or, in another example, a curved surface that does not have an uneven structure may have surface irregularities such as pits, waves, protrusions, or other deviations from the curved surface that occur as part of a manufacturing process, whereas a curved surface having an uneven structure may have variations that extend from, or that are recessed into the curved surface an amount greater than the depth of a pit or the height of a protrusion that occurs as part of the manufacturing process. The uneven structure may be configured to increase the surface area of the interface relative to the surface area of the interface without the uneven structure through the use of the variations. In some embodiments, the uneven structure may increase the surface area of the interface by at least 50%, by at least 100% or even greater than 200% relative to the interface without the uneven structure. For example, the ratio of the surface area of the uneven structure to the planar area occupied by the footprint of the uneven structure may be 1.5 or greater, 2 or greater or 3 or greater (where the area occupied by the footprint of the uneven structure corresponds to the area of the uneven structure occupied within a horizontal plane with respect to a plan view).

By forming the lower surface of at least one of the first impurity region and the second impurity region to have an uneven structure, high current drivability can be realized even with an ESD diode formed in a limited area. Therefore, the degree of integration may be improved by limiting the number of each of the first impurity region and the second impurity region, and the integrity of a signal input to/output from a pad to which the ESD diode is connected may be improved by reducing the capacitance of the ESD diode.

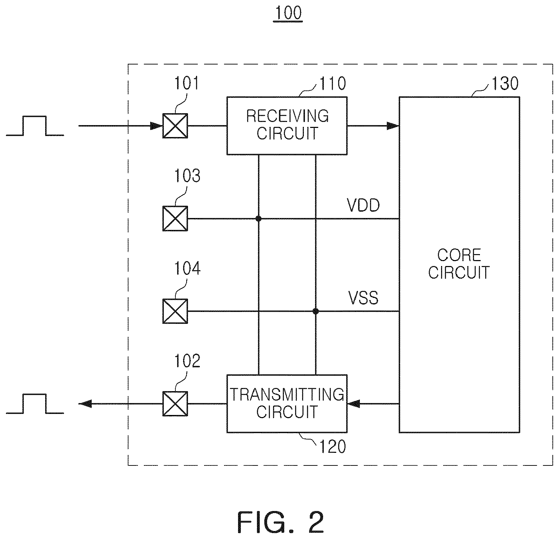

FIG. 2 is a block diagram schematically illustrating a semiconductor device 100 according to an embodiment of the present inventive concept. The semiconductor device 100 may correspond to semiconductor device 21 or semiconductor device 31 in Fig. 1.

Referring to FIG. 2, the semiconductor device 100 according to the present inventive concept may include signal pads 101 and 102, power supply pads 103 and 104, a receiving circuit 110, a transmitting circuit 120, a core circuit 130, and/or the like. The semiconductor device 100 may exchange a signal with another external semiconductor device through the signal pads 101 and 102. For example, the receiving circuit 110 may receive an external input signal through an input pad 101 of the signal pads 101 and 102, and transmit an external output signal through an output pad 102 of the signal pads 101 and 102.

Each of the receiving circuit 110, the transmitting circuit 120, and the core circuit 130 may include a plurality of semiconductor elements. The receiving circuit 110 may include a receiver, and the transmitting circuit 120 may include a driving circuit. The core circuit 130 may include various circuits necessary for the semiconductor device 100 to provide predetermined functions, such as a central processing unit (CPU), a graphics processing unit (GPU), an image signal processor (ISP), a neural processing unit (NPU), a modem, and/or the like. For example, when the semiconductor device 100 is a memory device, the core circuit 130 may include peripheral circuits that control memory cells, such as a row decoder, a page buffer, a voltage generator, and/or the like.

The receiving circuit 110 may process an external input signal input to a first signal pad 101 which may be an input pad and transmit it to the core circuit 130. Meanwhile, the transmitting circuit 120 may process a signal received from the core circuit 130 to generate an external output signal, and output the external output signal through a second signal pad 102 which may be an output pad. In an embodiment, each of the external input signal and the external output signal may be a signal having a predetermined frequency as illustrated in FIG. 2.

A power supply voltage VDD and a reference voltage VSS required for an operation of each of the receiving circuit 110, the transmitting circuit 120, and the core circuit 130 may be input to the power supply pads 103 and 104. For example, the power supply voltage VDD may be input to a first power supply pad 103, and the reference voltage VSS having a level lower than that of the power supply voltage VDD may be input to a second power supply pad 104.

In a state in which the pads 101 to 104 of the semiconductor device 100 are not connected to another semiconductor device, a high voltage caused by static electricity and/or the like may be applied, which application may be unintentional, to at least some of the pads 101 to 104. For example, under an ESD event condition in which a high voltage is applied to at least one of the signal pads 101 and 102 due to static electricity and/or the like, a very large current may flow in a semiconductor element included in the receiving circuit 110, the transmitting circuit 120 and/or the like, whereby the semiconductor element may be damaged. In an embodiment, the ESD event may occur in a situation where a physical body is in close proximity to at least one of the floated pads 101 to 104.

As such, in order to prevent damage to a semiconductor element that may occur under an ESD event condition, the receiving circuit 110, the transmitting circuit 120, and/or the like may include an ESD diode providing a movement path of a current (e.g., a conductive path for current to flow). For example, the receiving circuit 110 may include a plurality of ESD diodes, and each of the plurality of ESD diodes may be connected between the first signal pad 101 and the first power supply pad 103, or between the first signal pad 101 and the second power supply 104. Similarly, each of the plurality of ESD diodes included in the transmitting circuit 120 may be connected between the second signal pad 102 and the first power supply pad 103 or between the second signal pad 102 and the second power supply pad 104.

The ESD diode may provide a path through which a current flowing into the semiconductor device 100 flows under an ESD event condition. In an ideal case, a current generated by static electricity around the semiconductor device 100 and flowing into the signal pads 101 and 102 may flow to a clamp circuit that may be included in each of the receiving circuit 110 and the transmitting circuit 120, through at least one of the ESD diodes.

When the ESD diode is connected to each of the signal pads 101 and 102, if the current drivability of the ESD diode is not sufficient, the current caused by static electricity may not flow to the clamp circuit, but may instead flow into elements of the receiving circuit 110 or the transmitting circuit 120. Therefore, the ESD diode needs to be formed to have sufficient current drivability.

The ESD diode may include a first impurity region doped with N-type impurities and a second impurity region doped with P-type impurities to form a PN diode with a PN junction formed at an interface between the first impurity region and the second impurity region, and for example, the current drivability of the ESD diode may be sufficiently secured by increasing the interface areas of the first impurity region and the second impurity region. However, as the area of the ESD diode increases, the degree of integration of the semiconductor device 100 may decrease. In addition, as the number of metal lines connected to the first impurity region and the second impurity region in the ESD diode increases, the capacitance of the ESD diode may increase and the integrity of a signal input/output through the signal pads 101 and 102 may deteriorate, which may be evident as an eye margin of the signal decreasing.

In an embodiment of the present inventive concept, in order to realize an ESD diode having high current drivability without decreasing the degree of integration and increasing the capacitance, a lower surface (e.g., an interface area) of at least one of the first impurity region and the second impurity region may be formed to have an uneven structure. By forming the lower surface of at least one of the first impurity region and the second impurity region to have an uneven structure, current drivability in a limited area may be improved. Accordingly, the number of metal lines connected to the ESD diode may be reduced, and the capacitance of the ESD diode may be reduced so as to improve the integrity of a signal input to/output from the signal pads 101 and 102, which may be evident as an eye margin of the signal increasing. In addition, the degree of integration of the semiconductor device 100 may be improved by reducing the areas of the first impurity region and the second impurity region while maintaining the current drivability.

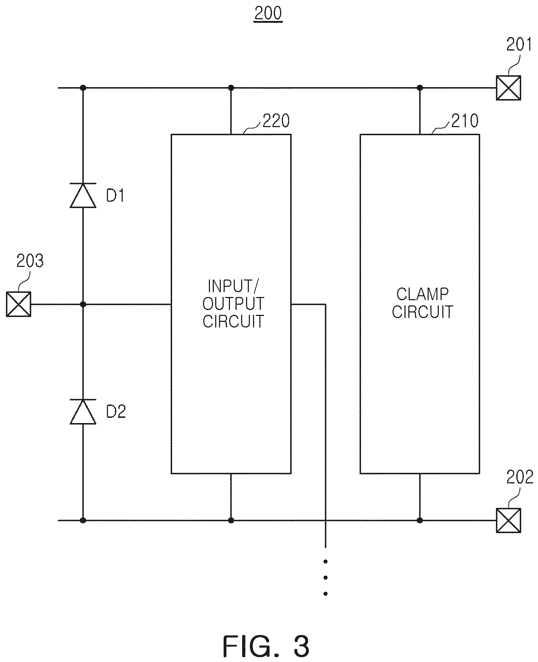

FIG. 3 is a drawing schematically illustrating a semiconductor device 200 according to an embodiment of the present inventive concept. The semiconductor device 200 may correspond to the semiconductor device 100 of Fig. 2.

Referring to FIG. 3, a semiconductor device 200 according to an embodiment of the present inventive concept may include a first power supply pad 201, a second power supply pad 202, a signal pad 203, a clamp circuit 210, and an input/output circuit 220. For example, the first power supply pad 201 may be a pad to which a power supply voltage is input, and the second power supply pad 202 may be a pad to which a reference voltage having a voltage level lower than that of the power supply voltage is input. Other elements are possible, and this description is not meant to be an exhaustive description of the elements that may be included in the semiconductor device 200.

The input/output circuit 220 may be connected to the signal pad 203 and send an output signal to the signal pad 203 or receive an input signal through the signal pad 203 (e.g., exchange signals). For example, some of the elements included in the input/output circuit 220 may receive the first power supply voltage from the first power supply pad 201, and some of them may receive the second power supply voltage from the second power supply pad 202.

The semiconductor device 200 may include a first ESD diode D1 connected between the signal pad 203 and the first power supply pad 201, and a second ESD diode D2 connected between the signal pad 203 and the second power supply pad 202. In the first ESD diode D1, an impurity region doped with N-type impurities may be connected to the first power supply pad 201 through a cathode, and an impurity region doped with P-type impurities may be connected to the signal pad 203 through an anode. Meanwhile, in the second ESD diode D2, an impurity region doped with N-type impurities may be connected to the signal pad 203 through a cathode, and an impurity region doped with P-type impurities may be connected to the second power supply pad 202 through an anode.

If a high current is applied to the signal pad 203 due to static electricity generated from the outside (e.g., externally), in an ideal case, the current caused by static electricity may flow to the second power supply pad 202 through the first ESD diode D1 and the clamp circuit 210. Accordingly, the current caused by static electricity may not flow into the input/output circuit 220 and/or the like involved in the actual operation of the semiconductor device 200, and the semiconductor device 200 may be effectively protected from static electricity.

When static electricity is applied to the signal page 203, a very high current can flow thereinto momentarily. Therefore, if the current drivability of the ESD diodes D1 and D2 is insufficient, the current may directly flow into the input/output circuit 220 rather than the ESD diodes D1 and D2, whereby damage may occur to the semiconductor device 200.

In an embodiment of the present inventive concept, the degree of integration and the reliability of the semiconductor device 200 may both be enhanced by ensuring sufficient current drivability of each of the ESD diodes D1 and D2 and at the same time realizing each of the ESD diodes D1 and D2 in a limited area. In addition, by forming the ESD diodes D1 and D2 in the limited areas, the capacitance of each of the ESD diodes D1 and D2 may be reduced, thereby increasing the integrity of a signal input to/output from the signal pad 203, which may be evident as an increased eye margin of the signal.

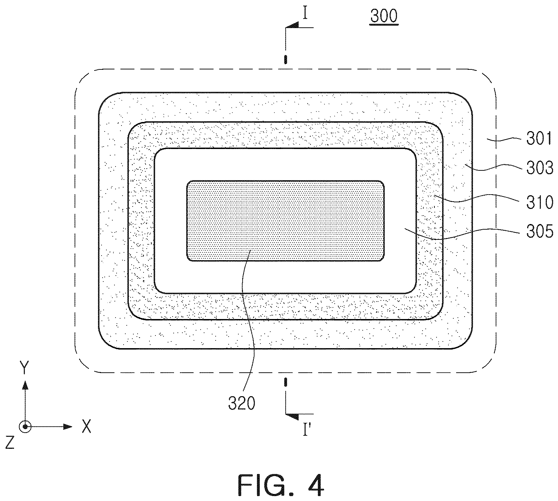

FIGS. 4 to 7 are drawings schematically illustrating an ESD diode 300 included in a semiconductor device according to an embodiment of the present inventive concept.

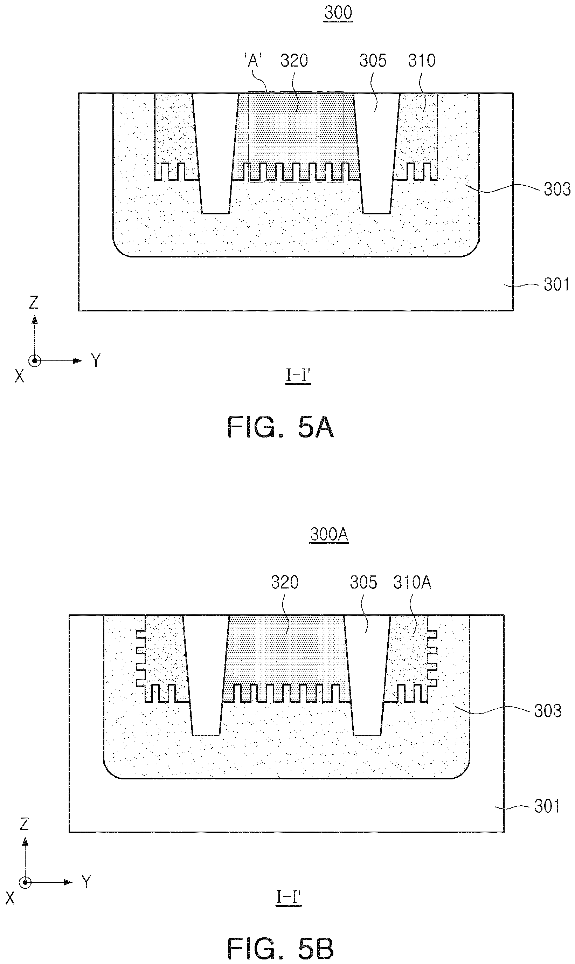

FIG. 4 is a plan view illustrating an ESD diode 300 according to an embodiment of the present inventive concept, and FIGS. 5A and 5B are cross-sectional views taken in a direction I-I' in FIG. 4. Referring to FIGS. 4 and 5A, an ESD diode 300 according to an embodiment of the present inventive concept may include a first impurity region 310 and a second impurity region 320 formed on a substrate 301. Each of the first impurity region 310 and the second impurity region 320 may be formed in a first well region 303 of the substrate 301.

In the ESD diode 300 shown in FIGS. 4 and 5A, the first impurity region 310 may be doped with impurities of a first conductivity type and the second impurity region 320 may be doped with impurities of a second conductivity type different from the first conductivity type. In an embodiment, the first impurity region 310 may be doped with N-type impurities and the second impurity region 320 may be doped with P-type impurities to form a PN diode having a PN junction formed at the interface (e.g., the lower surfaces) of the impurity regions and a depletion layer in the first well region 310 extending between the lower surface of the first impurity region 310 and the lower surface of the second impurity region 320.

An element isolation layer 305 may be disposed between the first impurity region 310 and the second impurity region 320. The first impurity region 310 may formed in a shape surrounding the second impurity region 320 in directions parallel to an upper surface of the substrate 301 with the element isolation layer 305 interposed therebetween. For example, in the first impurity region 310 may surround the second impurity region 320 in a first direction (e.g., an X-axis direction) and a second direction (e.g., a Y-axis direction). The first direction and the second direction may be in a plane parallel to the upper surface of the substrate 301. The element isolation layer 305 may be formed of an insulating material such as a silicon oxide, a silicon nitride, and/or the like, and have a thickness greater than a thickness of the first impurity region 310 and the second impurity region 320 in a third direction (e.g., a Z-axis direction) perpendicular to the upper surface of the substrate 301, as illustrated in FIG. 5A.

The ESD diode 300 may be the first ESD diode D1 in the embodiment described above with reference to FIG. 3. The first well region 303 may be a deep N-well region doped with N-type impurities. The N-type impurities may be the same or similar in the first well region 303 and the first impurity region 310. A doping concentration of the first well region 303 may be lower than that of the first impurity region 310.

As illustrated in FIG. 5A, a lower surface of each of the first impurity region 310 and the second impurity region 320 may have an uneven structure. However, in other embodiments, only one of the first impurity region 310 and the second impurity region 320 may have a lower surface having an uneven structure. For example, in some embodiments, only the first impurity region 310 may have a lower surface having an uneven structure. In the example of FIG. 5A, the uneven structure of the lower surface includes a series of projections of the first well region 303 extending upward from a lowest extent of an impurity region into the impurity region. Although shown as rectangular in shape, the projections may have other shapes such as a sawtooth shape or curves. In some embodiments, each projection may extend upward a distance that is at least 10% of the thickness of the impurity region as measured from a top surface of the impurity region to the lowest extent of the impurity region. In some embodiments, each projection may extend upward a distance that is at least 5% of a width of the impurity region. Additionally, in some embodiments, the trenches formed between each projection may have an aspect ratio (height/width) of at least 1.5, such as 2 or greater, or 3 or greater. The projections may repeat in a regular pattern being spaced apart at a pitch, wherein the heights of the projections are at least 1.5 time as large as the pitch, such as 2 times or greater, or 3 times or greater than the pitch. The regular pattern may occur in two dimensions such that the projections occur in a checkerboard pattern, crossing pattern, or other pattern when viewed from above.

In addition, as illustrated in FIG. 5B, in some embodiments, a first impurity region 310A may have an uneven structure not only on the lower surface but also on a side surface thereof. The embodiment of FIG. 5B illustrates that a side surface contacting the first well region 303 has an uneven structure, but a side surface contacting the element isolation layer 305 may not have an uneven structure. Furthermore, in other embodiments, the element isolation layer 305 between the first impurity region 310A and the second impurity region 320 may be omitted. In such embodiments, an uneven structure may be formed on a side surface contacting the second impurity region 320. Alternatively, in embodiment in which the element isolation layer 305 is present, an uneven structure may be formed on a side surface of the first impurity region 310A contacting the element isolation layer 305.

By forming the lower surface(s) and/or the side surface(s) of the first impurity regions 310 or 310A and/or the second impurity region 320 in an uneven structure, an area of a junction surface (e.g., a P-N junction) between the first well region 303 and the first impurity regions 310 or 310A and/or the second impurity regions 320 may be increased, thereby enhancing current drivability of the ESD diode 300. Therefore, an ESD diode having sufficient current drivability can be realized with one (e.g., a single) first impurity region 310 or 310A and one second impurity region 320 surrounding the first impurity region 310 or 310A.

Since the ESD diode 300 can be realized with a limited number of impurity regions 310, 310A, and 320, the degree of integration of a semiconductor device including the ESD diode 300 can be improved. In addition, a capacitance caused by metal lines respectively connected to the impurity regions 310, 310A, and 320, in addition to a capacitance existing on a junction surface of the impurity regions 310, 310A, and 320, may be reduced, thereby reducing the effect of the ESD diode 300 on the integrity of a signal input/output through the signal pad to which the ESD diode 300 is connected, which will be described later.

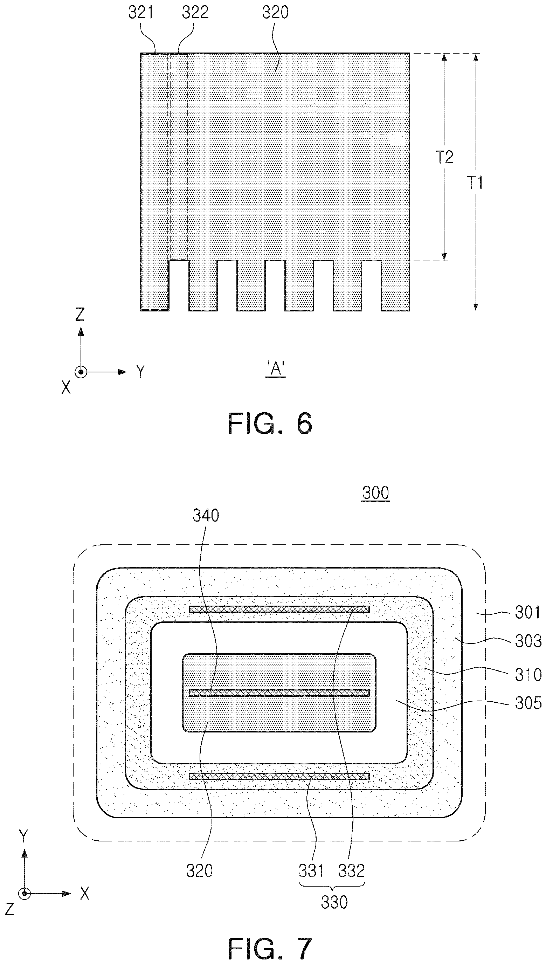

FIG. 6 is an enlarged view of area A in FIG. 5A. Referring to FIG. 6, the second impurity region 320 included in the ESD diode 300 may include a plurality of regions 321 and 322 having different thicknesses in the third direction perpendicular to the upper surface of the substrate 301. For example, the plurality of first regions 321 may have a first thickness T1 in the third direction, and the plurality of second regions 322 may have a second thickness T2 in the third direction.

However, the thickness of each of the plurality of first regions 321 may not be completely equal to the first thickness T1. Similarly, the thickness of each of the plurality of second regions 322 may not be exactly the same as the second thickness T2. In addition, the profile of a lower surface of the second impurity region 320 due to a thickness difference between the plurality of first regions 321 and the plurality of second regions 322 may have an uneven structure other than that shown in FIG. 6, such as a wavy uneven structure, a curved bump uneven structure, or a saw shaped uneven structure.

The plurality of first regions 321 and the plurality of second regions 322 may be formed by intentionally controlling an impurity implantation process for forming the second impurity region 320. For example, the plurality of first regions 321 may be formed to have a thickness greater than that of the plurality of second regions 322 by disposing a mask layer exposing positions only corresponding to the plurality of first regions 321 and performing an impurity implantation process. Alternatively, an impurity implantation process may be performed first, and then a further impurity implantation process may be performed at positions only corresponding to the plurality of first regions 321. As such, by intentionally controlling the impurity implantation process, a difference between the first thickness T1 and the second thickness T2 may be greater than a difference due to a simple process deviation.

Referring to FIG. 7, a plurality of metal lines (which are an example of metal wirings) including first metal lines 330 and second metal lines 340 may be connected to the first impurity region 310 of the ESD diode 300 and to the second impurity region 320 of the ESD diode 300, respectively. Each of the plurality of metal lines 330 and 340 may have a line shape extending in the first direction. For example, the first metal lines 330 and the second metal line 340 may be contact structures contacting the first impurity region 310 and the second impurity region 320, respectively.

Two or more first metal lines 331 and 332 may be connected to the first impurity region 310, which surrounds the second impurity region 320. The first metal lines 331 and 332 may be spaced apart from each other in the second direction and may contact different positions of the first impurity region 310. The second metal line 340 may be disposed between the first metal lines 331 and 332 in the second direction, and the first metal lines 331 and 332 and the second metal line 340 may be arranged in the second direction at equal intervals.

The first metal lines 331 and 332 may contact the first impurity region 310, which is doped with N-type impurities, forming a cathode of the ESD diode 300, and the second metal line 340 may contact the second impurity region 320, which is doped with P-type impurities, forming an anode of the ESD diode 300. For example, the first metal lines 331 and 332 may be connected to a power supply line configured to supply a first power supply voltage or a second power supply voltage. The second metal line 340 may be connected to a signal pad configured to input/output a signal.

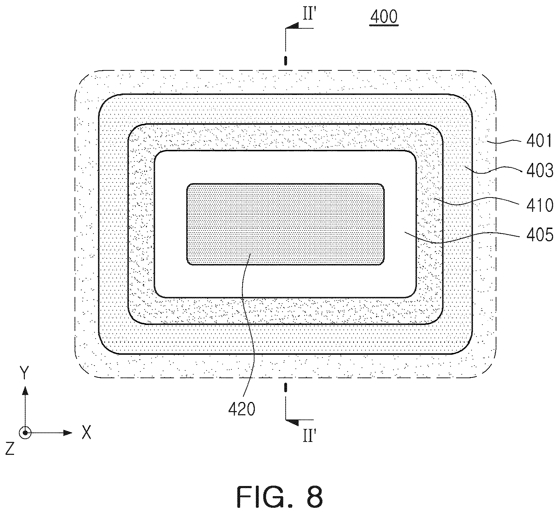

FIGS. 8 to 11 are drawings schematically illustrating an ESD diode included in a semiconductor device according to an embodiment of the present inventive concept.

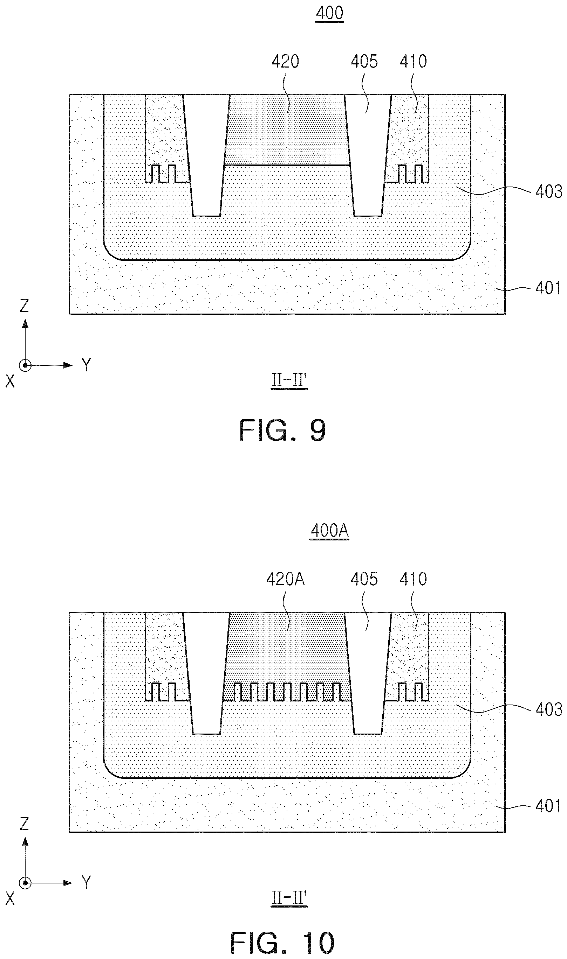

FIG. 8 is a plan view illustrating an ESD diode 400 according to an embodiment of the present inventive concept, and FIG. 9 is a cross-sectional view taken in a direction II-II' of FIG. 8. Referring first to FIGS. 8 and 9, the ESD diode 400 according to an embodiment of the present inventive concept may include a third impurity region 410 and a fourth impurity region 420 formed on a substrate. Each of the third impurity region 410 and the fourth impurity region 420 may be formed in a second well region 403 of the substrate.

In the ESD diode 400 described with reference to FIGS. 8 and 9, the third impurity region 410 may be doped with N-type impurities and the fourth impurity region 420 may be doped with P-type impurities. Meanwhile, the second well region 403 may be doped with P-type impurities. The second well region 403 may be a pocket P-well formed in a third well region 401 doped with N-type impurities. The ESD diode 400 may be the second ESD diode D2 according to the embodiment described above with reference to FIG. 3.

An element isolation layer 405 may be disposed between the third impurity region 410 and the fourth impurity region 420. The third impurity region 410 may be surrounded by the element isolation layer 405 and the fourth impurity region 420. Therefore, as illustrated in FIG. 8, the element isolation layer 405 may be disposed between the third impurity region 410 and the fourth impurity region in a first direction (e.g., an X-axis direction) and a second direction (e.g., a Y-axis direction) parallel to an upper surface of the substrate. The element isolation layer 405 may have a thickness greater than a thickness of the impurity regions 410 and 420 in a third direction (e.g., a Z-axis direction) perpendicular to the upper surface of the substrate.

In the embodiment shown in FIG. 9, a lower surface of the third impurity region 410 may have a structure different from that of a lower surface of the fourth impurity region 420. For example, the lower surface of the third impurity region 410 may have an uneven structure unlike the lower surface of the fourth impurity region 420. The third impurity region 410 may include regions having different thicknesses and alternately disposed in a horizontal direction such as the first direction or the second direction.

The ESD diode 300 according to the embodiment described with reference to FIGS. 4 and 5 may be referred to as a first ESD diode, and may be connected between a first power supply pad configured to receive a first power supply voltage and a signal pad. Meanwhile, the ESD diode 400 according to an embodiment described with reference to FIGS. 8 and 9 may be referred to as a second ESD diode, and may be connected between a second power supply pad configured to receive a second power supply voltage less than the first power supply voltage and a signal voltage of the signal pad. The lower surface of each of the first impurity region doped with N-type impurities in the first ESD diode and the third impurity region doped with N-type impurities in the second ESD diode may have an uneven structure. However, depending on embodiments, as illustrated in FIG. 10, a lower surface of each of a third impurity region 410 and a fourth impurity region 420A of an ESD diode 400A may have an uneven structure.

As described above, by forming the lower surface(s) of the third impurity regions 410 and/or the fourth impurity region 420 or 420A to have an uneven structure, an area of a junction surface between the second well region 403 and the impurity regions 410, 420 and 420A may be increased, thereby enhancing current drivability of the ESD diode 400 or 400A while forming the ESD diode 400 or 400A with a limited area. The ESD diodes 400 or 400A having excellent current drivability may be realized with a limited area and a small number of the impurity regions 410, 420, and 420A, thereby improving the degree of integration of the semiconductor device including the ESD diode 400 or 400A. In addition, since the number of metal lines connected to each of the impurity regions 410, 420, and 420A may be reduced due to the small number of impurity regions 410, 420, and 420A, a capacitance due to the metal lines may be reduced. Accordingly, the integrity of a signal input/output through a signal pad to which the ESD diode 400 or 400A are connected may be improved, which may be evident by an increased eye margin of the signal.

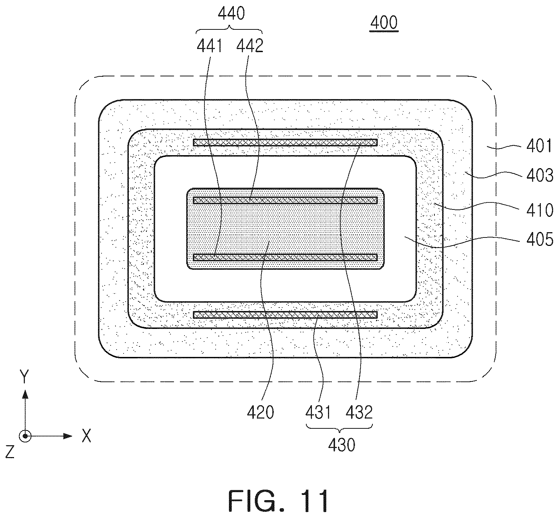

Referring to FIG. 11, the ESD diode 400 may include a plurality of metal lines including first metal lines 430 connected to the third impurity region 410 of the ESD diode 400 and second metal lines 440 connected to the fourth impurity region 420. Each of the plurality of metal lines 430 and 440 may have a line shape extending in the first direction and may be provided as a contact structure contacting the impurity regions 410 and 420, respectively.

Referring to FIG. 11, two or more first metal lines 431 and 432 may be connected to the third impurity region 410, and two or more second metal lines 441 and 442 may be connected to the fourth impurity region 420. Each of the first metal lines 431 and 432 and the second metal lines 441 and 442 may be arranged to be spaced apart from one another at equal intervals along the second direction.

The first metal lines 431 and 432 may contact the third impurity region 410 doped with N-type impurities to provide a cathode of the ESD diode 400, and the second metal lines 441 and 442 may contact the fourth impurity region 420 doped with P-type impurities to provide an anode of the ESD diode 400. For example, the first metal lines 431 and 432 may be connected to a signal pad configured to input/output a signal, and the second metal lines 441 and 442 may be connected to a power supply line configured to supply a first power supply voltage or a second power supply voltage.

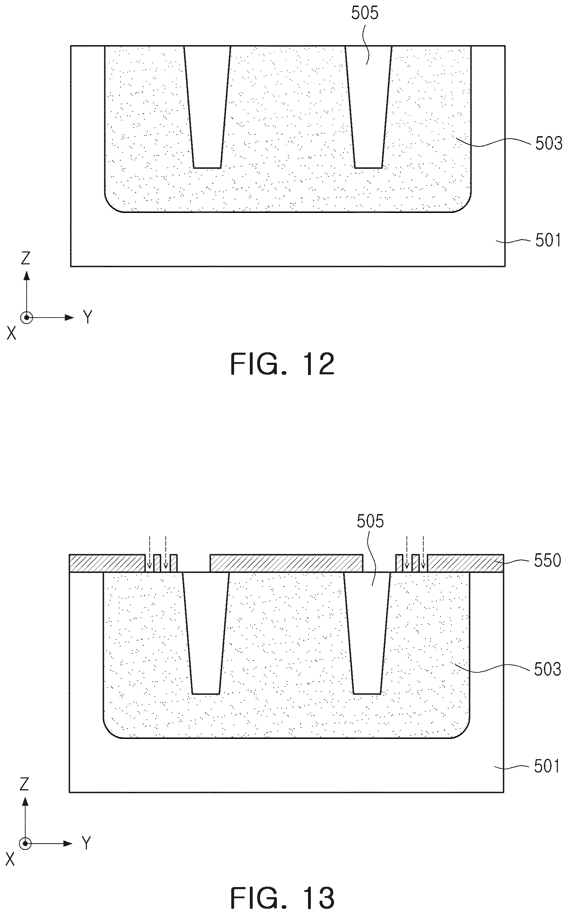

FIGS. 12 to 16 are drawings provided for describing a manufacturing process of an ESD diode included in a semiconductor device according to an embodiment of the present inventive concept;

An ESD diode manufactured by the manufacturing process described with reference to FIGS. 12 to 16 may include an anode connected to a signal pad configured to output or receive a signal, and a cathode connected to a first power supply pad configured to supply a first power supply voltage. Referring first to FIG. 12, the manufacturing process of the ESD diode according to an embodiment of the present inventive concept may begin with forming a first well region 503 and an element isolation layer 505 on a substrate 501.

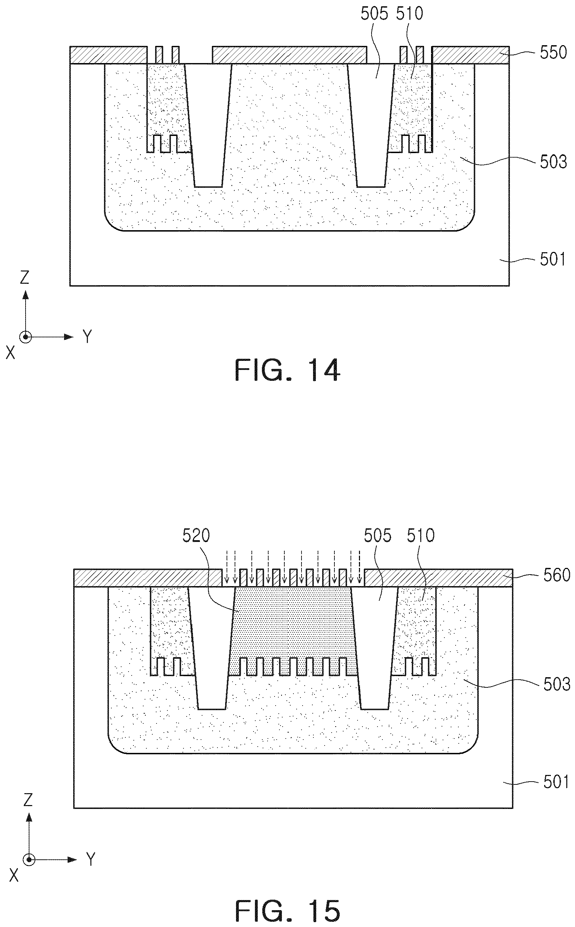

Next, referring to FIG. 13, a first mask layer 550 may be formed on an upper surface of the substrate 501. The first mask layer 550 may be formed to expose a region of a portion of the first well region 503, and a first doping process may be performed in which impurities of a first conductivity type are implanted through the region exposed by the first mask layer 550. As illustrated in FIG. 13, impurities of the first conductivity type may be implanted into the first well region 503 by means of the region exposed by the first mask layer 550, and therefore a first impurity region 510 having a lower surface with an uneven structure may be formed in the first well region 503, as illustrated in FIG. 14. The first impurity region 510 may be formed outside the element isolation layer 505.

For example, the first mask layer 550 may have patterns exposing only a portion of the first well region 503. In the first doping process, impurities of the first conductivity type may be implanted into the first well region 503 through spaces between the patterns, and then diffused therein so as to form the first impurity region 510. Accordingly, the first impurity region 510 may be formed to have a relatively large thickness under the portion which was not covered by the patterns of the first mask 550 and exposed to the doping process. The impurities of the first conductivity type implanted in the first doping process may be N-type impurities.

Next, referring to FIG. 15, the first mask layer 550 may be removed and a second mask layer 560 may be formed on the upper surface of the substrate 501. For example, the first impurity region 510 may be completely covered by the second mask layer 560. The second mask layer 560 may have patterns exposing a region of a portion of the first well region 503 surrounded by the element isolation layer 505. As illustrated in FIG. 15, a second doping process may be performed in which impurities of a second conductivity type are implanted through spaces between the patterns of the second mask layer 560. The impurities of the second conductivity type may be P-type impurities.

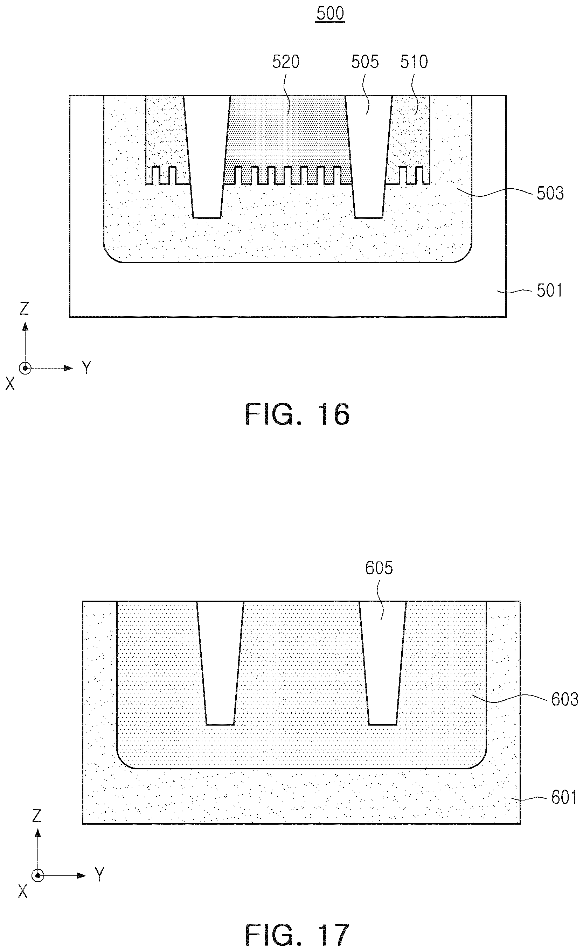

Referring to FIG. 15, a second impurity region 520 may be formed by the second doping process. Similar to the first doping process for forming the first impurity region 510, since the impurities of the second conductivity type are implanted between the patterns of the second mask layer 560 in the second doping process, the second impurity region 520 having a relatively smaller thickness may be formed under the patterns of the second mask layer 560 compared to the thickness of the second impurity region 520 formed between the patterns of the second mask layer 560. Therefore, as illustrated in FIG. 15, a lower surface of the second impurity region 520 may also have an uneven structure. Thereafter, an ESD diode 500 may be formed by removing the second mask layer 560, as illustrated in FIG. 16. A first metal line contacting the first impurity region 510 and a second metal line contacting the second impurity region 520 may be added. For example, the first metal line may be connected to a power supply line configured to supply a power supply voltage, and the second metal line may be connected to a signal pad configured to receive or transmit a signal.

FIGS. 17 to 21 are drawings provided for describing a manufacturing process of an ESD diode included in a semiconductor device according to an embodiment of the present inventive concept.

An ESD diode manufactured by the manufacturing process described with reference to FIGS. 17 to 21 may include a cathode connected to a signal pad configured to output or receive a signal, and an anode connected to a second power supply pad configured to supply a second power supply voltage. Referring first to FIG. 17, the manufacturing process of an ESD diode according to an embodiment of the present inventive concept may begin with forming a P-well region 603 in an N-well region 601 formed on a substrate, and forming an element isolation layer 605 in the P-well region 603. For example, the N-well region 601 may be a deep N-well region, and the P-well region 603 may be a pocket P-well region.

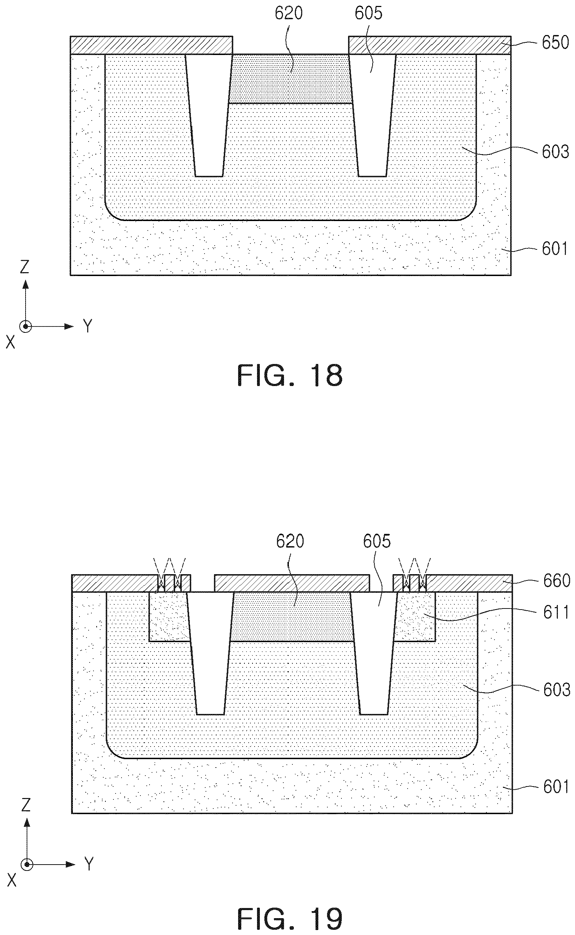

Next, referring to FIG. 18, a first mask layer 650 may be formed on the substrate. The first mask layer 650 may be formed to expose a region of a portion of the P-well region 603 surrounded by the isolation layer 605, and a first doping process may be performed in which impurities of a first conductivity type are implanted through the region exposed by the first mask layer 650. A second impurity region 620 may be first formed in the P-well region 603 by the first doping process. For example, the second impurity region 620 may be a region doped with P-type impurities.

Next, referring to FIG. 19, the first mask layer 650 may be removed and a second mask layer 660 having predetermined patterns may be formed on the substrate. The second mask layer 660 may include patterns that completely shield the second impurity region 620 and expose a portion of the P-well region 603 outside the element isolation layer 605. If the second mask layer 660 is formed as illustrated in FIG. 19, a second doping process may be performed in which N-type impurities are implanted into the P-well region 603 exposed between the patterns of the second mask layer 660. In the second doping process, the N-type impurities may be implanted at an incident angle less than 90 degrees with respect to an upper surface of the P-well region 603, as illustrated in FIG. 19, and therefore, a first upper impurity region 611 having a substantially flat lower surface may be formed as illustrated in FIG. 19.

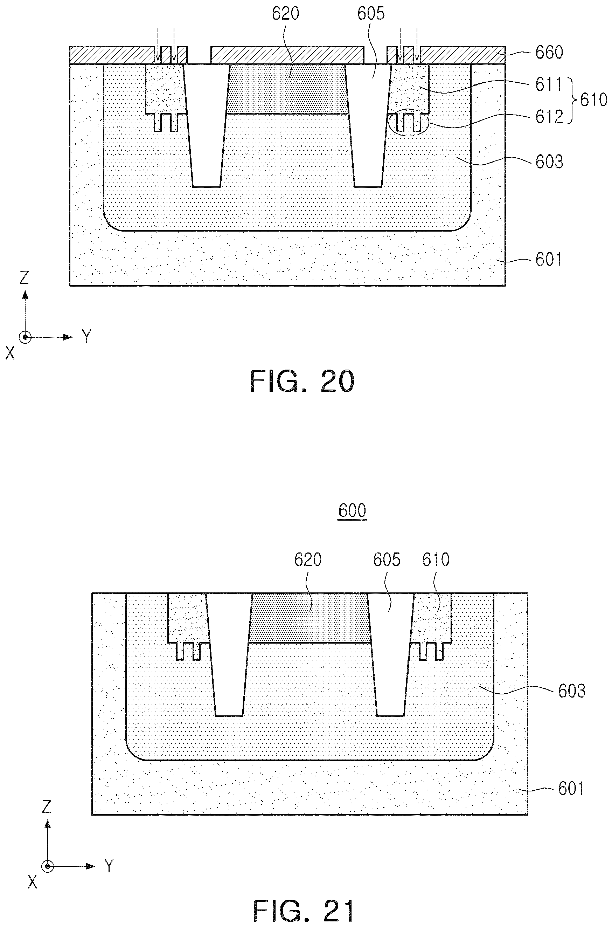

Next, referring to FIG. 20, a third doping process may be performed in which N-type impurities are additionally implanted into the first upper impurity region 611 exposed by the patterns of the second mask layer 660. Unlike the second doping process, in the third doping process, the N-type impurities may be implanted in a direction substantially perpendicular to an upper surface of the first upper impurity region 611. Therefore, as illustrated in FIG. 20, under a space where the patterns of the second mask layer 660 are not formed (e.g., a space between the patterns of the second mask layer 660) and the first upper impurity region 611 is exposed to the third doping process, a second impurity region 612, to which a region doped with the N-type impurities extends, may be formed. The formation of the second lower impurity region 612 results in a lower surface of the first impurity region 610 to be formed with an uneven structure.

Thereafter, the ESD diode 600 may be formed as illustrated in FIG. 21 by removing the second mask layer 660. A first metal line contacting the first impurity region 610 and a second metal line contacting the second impurity region 620 may be added. The first metal line may be connected to a signal pad, and the second metal line may be connected to a power supply line configured to supply a power supply voltage.

In the above, it is assumed that the first ESD diode will be connected between the first power supply pad configured to receive the first power supply voltage and the signal pad in the manufacturing process shown in FIGS. 12 to 16, and it is assumed that the second ESD diode will be connected between the first power supply pad configured to receive the first power supply voltage and the signal pad in the manufacturing process shown in FIGS. 17 to 21, but embodiments are not necessarily limited thereto. For example, the impurity regions of the first ESD diode may be formed by the doping process described with reference to FIGS. 19 and 20. Alternatively, the impurity regions of the second ESD diode may be formed by the doping process described with reference to FIGS. 13 to 15.

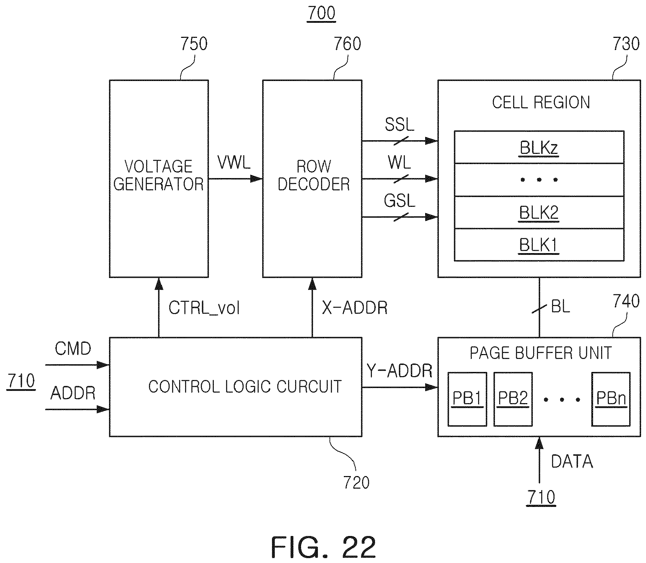

FIGS. 22 to 23 are drawings schematically illustrating a semiconductor device according to an embodiment of the present inventive concept.

Referring to FIG. 22, a semiconductor device 700 according to an embodiment of the present inventive concept may include a control logic circuit 720, a cell region 730, a page buffer unit 740, a voltage generator 750, a row decoder 760, and/or the like. The semiconductor device 700 may also further include an interface circuit 710 for exchanging a signal with another external device, and may further include a column logic, a pre-decoder, a temperature sensor, a command decoder, an address decoder, a source driver, and/or the like. The semiconductor device 700 may be a memory device configured to store data.

The control logic circuit 720 may control overall operations of the semiconductor device 700. The control logic circuit 720 may output various control signals in response to a command signal CMD and/or an address signal ADDR received by the interface circuit 710. For example, the control logic circuit 720 may output a voltage control signal CTRL_vol, a row address X-ADDR, and a column address Y-ADDR.

The cell region 730 may include a plurality of memory blocks BLK1 to BLKz (where z is a positive integer), and each of the plurality of memory blocks BLK1 to BLKz may include a plurality of memory cells. In an embodiment, the plurality of memory blocks BLK1 to BLKz may be separated by first isolation regions comprising an insulating material, and second isolation regions different from the first isolation regions may be disposed inside each of the plurality of memory blocks BLK1 to BLKz. For example, each of the second isolation regions may have a structure different from that of the first isolation regions.

For example, the plurality of memory blocks BLK1 to BLKz may include main blocks configured to store data, and at least one spare block configured to store data required for the operations of the semiconductor device 700. The cell region 730 may be connected to the page buffer unit 40 through bit lines BL, and may be connected to the row decoder 760 through word lines WL, string select lines SSL, and ground select lines GSL.

In exemplary embodiments, the cell region 730 may include a three-dimensional memory cell array, and the three-dimensional memory cell array may include a plurality of NAND strings. Each of the NAND strings may include memory cells, respectively connected to word lines vertically stacked on a substrate. U.S. Patent No. 7,679,133, U.S. Patent No. 8,553,466, U.S. Patent No. 8,654,587, U.S. Patent No. 8,559,235, and U.S. Patent Application Publication No. 2011/0233648 are incorporated herein by reference in their entirety. In exemplary embodiments, the cell region 730 may include a two-dimensional memory cell array, and the two-dimensional memory cell array may include a plurality of NAND strings arranged in row and column directions.

The page buffer unit 740 may include a plurality of page buffers PB1 to PBn (where n is an integer greater than or equal to 3), and the plurality of page buffers PB1 to PBn may be connected to the memory cells through a plurality of bit lines BL, respectively. The page buffer unit 14 may select at least one of the bit lines BL in response to the column address Y-ADDR. The page buffer unit 740 may operate as a write driver or a sense amplifier, depending on an operation mode. For example, during a program operation, the page buffer unit 740 may apply a bit line voltage corresponding to data to be programmed to a selected bit line. During a read operation, the page buffer unit 740 may sense a current or a voltage of a selected bit line to sense data stored in the memory cell. The data to be programmed in the cell region 730 by the program operation and the data read from the cell region 730 by the read operation may be input/output through the interface circuit 710.

The voltage generator 750 may generate various types of voltages for performing program, read, and erase operations based on the voltage control signal CTRL_vol. For example, the voltage generator 750 may generate a program voltage, a read voltage, a pass voltage, a program verification voltage, an erase voltage, and/or the like. In an embodiment, the control logic circuit 720 may control the voltage generator 750 to generate the voltages for performing the program, read, and erase operations using data stored in a spare block. Some of the voltages generated by the voltage generator 750 may be input to the word lines WL as a word line voltage VWL by the row decoder 760, and some of the voltages may be input to a common source line by a source driver.

The row decoder 760 may select one of the plurality of string selection lines SSL and select one of the plurality of word lines WL in response to the row address X-ADDR. For example, the row decoder 760 may apply a program voltage and a program verification voltage to a selected word line during a program operation, and may apply a read voltage to the selected word line during a read operation.

The interface circuit 710 may include a plurality of pads for exchanging the command signal CMD, the address signal ADDR, the data signal DATA, and/or the like with another external device, and an ESD diode (for example any of the ESD diodes described before) may be connected to at least one of the plurality of pads. For example, a first ESD diode and a second ESD diode may be connected to a signal pad for input/output the data signal DATA. The first ESD diode may be connected to a first power supply pad configured to receive a first power supply voltage and the signal pad. Meanwhile, the second ESD diode may be connected to a second power supply pad configured to receive a second power supply voltage less than the first power supply voltage and the signal pad.

Each of the first ESD diode and the second ESD diode may has a junction capacitance generated at a junction surface between a P-type impurity region and an N-type impurity region, and a line capacitance generated between metal lines connected to the N-type impurity region and the P-type impurity region. The capacitance of each of the first ESD diode and the second ESD diode may cause an eye margin of a signal input to/output from the signal pad to decrease.

In order to reduce the line capacitance in each of the first ESD diode and the second ESD diode, the number of metal lines needs to be reduced. However, if the number of metal lines is reduced, an area and/or number of at least one of the P-type impurity region and the N-type impurity region may be required to decrease along therewith. Accordingly, current drivability of the first ESD diode and the second ESD diode may be reduced by reducing the line capacitance, and therefore, the semiconductor device 700 may not be sufficiently protected from a current flowing thereinto due to static electricity and/or the like.

An embodiment of the present inventive concept proposes an ESD diode capable of providing high current drivability while reducing an area and number of P-type impurity region and N-type impurity region. For example, in an ESD diode according to an embodiment of the present inventive concept, a lower surface of at least one of the P-type impurity regions connected to an anode and the N-type impurity regions connected to a cathode may have an uneven structure. The lower surface may be a surface where the P-type impurity region and/or the N-type impurity region contact(S) a well region, and therefore, sufficient current drivability may be secured while reducing the area of the ESD diode.

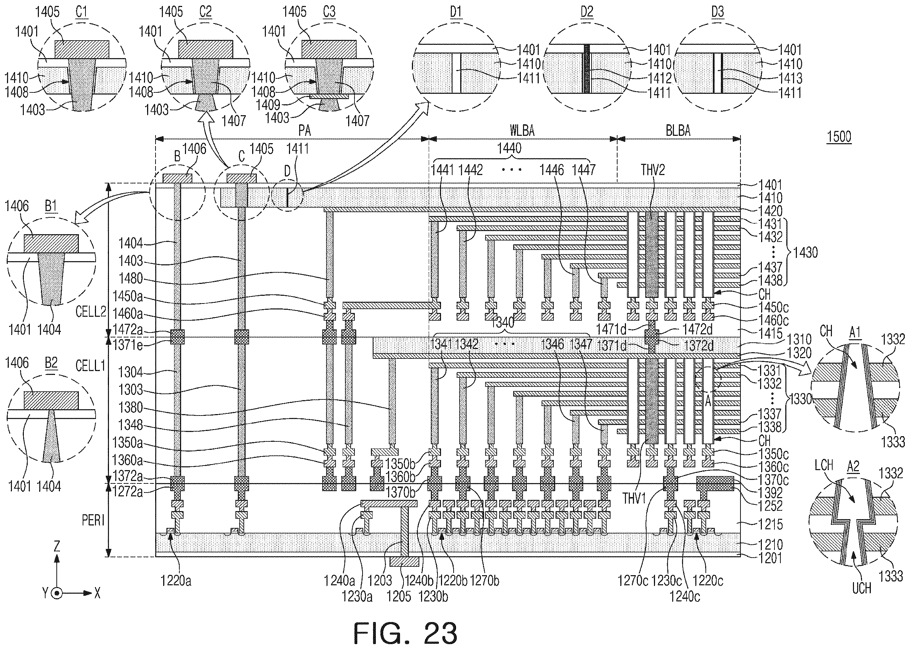

Referring to FIG. 23, a non-volatile memory device 1500 may have a chip-to-chip (C2C) structure. At least one upper chip including a cell region CELL and a lower chip including a peripheral circuit region PERI may be manufactured separately, and then, the at least one upper chip and the lower chip may be connected to each other by a bonding method to realize the C2C structure. For example, the bonding method may mean a method of electrically or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. In certain embodiments, the bonding metal patterns may be formed of aluminum (Al) or tungsten (W).

The non-volatile memory device 1500 may include the at least one upper chip including the cell region. For example, as illustrated in FIG. 23, the non-volatile memory device 1500 may include two upper chips. However, the number of the upper chips is not limited thereto. In the case in which the non-volatile memory device 1500 includes the two upper chips, a first upper chip including a first cell region CELL1, a second upper chip including a second cell region CELL2 and the lower chip including the peripheral circuit region PERI may be manufactured separately, and then, the first upper chip, the second upper chip and the lower chip may be connected to each other by the bonding method to manufacture the non-volatile memory device 1500. The first upper chip may be turned over and then may be connected to the lower chip by the bonding method, and the second upper chip may also be turned over and then may be connected to the first upper chip by the bonding method. Hereinafter, upper and lower portions of each of the first and second upper chips will be defined based on before each of the first and second upper chips is turned over. An upper portion of the lower chip may mean an upper portion defined based on a +Z-axis direction, and the upper portion of each of the first and second upper chips may mean an upper portion defined based on a -Z-axis direction in FIG. 23. However, embodiments of the present inventive concept are not limited thereto. In certain embodiments, only one of the first upper chip and the second upper chip may be turned over and then may be connected to a corresponding chip by the bonding method.

Each of the peripheral circuit region PERI and the first and second cell regions CELL1 and CELL2 of the non-volatile memory device 1500 may include an external pad bonding region PA, a word line bonding region WLBA, and a bit line bonding region BLBA.

The peripheral circuit region PERI may include a first substrate 1210 and a plurality of circuit elements 1220a, 1220b and 1220c formed on the first substrate 1210. An interlayer insulating layer 1215 including one or more insulating layers may be provided on the plurality of circuit elements 1220a, 1220b and 1220c, and a plurality of metal lines electrically connected to the plurality of circuit elements 1220a, 1220b and 1220c may be provided in the interlayer insulating layer 1215. For example, the plurality of metal lines may include first metal lines 1230a, 1230b and 1230c connected to the plurality of circuit elements 1220a, 1220b and 1220c, respectively, and second metal lines 1240a, 1240b and 1240c formed on the first metal lines 1230a, 1230b and 1230c, respectively. The plurality of metal lines may be formed of at least one of various conductive materials. For example, the first metal lines 1230a, 1230b and 1230c may be formed of tungsten having a relatively high electrical resistivity, and the second metal lines 1240a, 1240b and 1240c may be formed of copper having a relatively low electrical resistivity.

The first metal lines 1230a, 1230b and 1230c and the second metal lines 1240a, 1240b and 1240c are illustrated and described in the present embodiments. However, embodiments of the present inventive concept are not limited thereto. In certain embodiments, at least one or more additional metal lines may further be formed on the second metal lines 1240a, 1240b and 1240c. In this case, the second metal lines 1240a, 1240b and 1240c may be formed of aluminum, and at least some of the additional metal lines formed on the second metal lines 1240a, 1240b and 1240c may be formed of copper having an electrical resistivity lower than that of aluminum of the second metal lines 1240a, 1240b and 1240c.

The interlayer insulating layer 1215 may be disposed on the first substrate 1210, and may include an insulating material such as a silicon oxide, a silicon nitride, and/or the like.

Each of the first and second cell regions CELL1 and CELL2 may include at least one memory block. The first cell region CELL1 may include a second substrate 1310 and a common source line 1330. A plurality of word lines 1330 (1331 to 1338) may be stacked on the second substrate 1310 in a direction (i.e., the Z-axis direction) perpendicular to an upper surface of the second substrate 1310. String selection lines and a ground selection line may be disposed on and under the word lines 1330, and the plurality of word lines 1330 may be disposed between the string selection lines and the ground selection line. Likewise, the second cell region CELL2 may include a third substrate 1410 and a common source line 1420, and a plurality of word lines 1430 (1431 to 1438) may be stacked on the third substrate 1410 in a direction (i.e., the Z-axis direction) perpendicular to an upper surface of the third substrate 1410. Each of the second substrate 1310 and the third substrate 1410 may be formed of at least one of various materials, and may be, for example, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell regions CELL1 and CELL2.

In some embodiments, as illustrated in a region 'A1,' the channel structure CH may be provided in the bit line bonding region BLBA, and may extend in the direction perpendicular to the upper surface of the second substrate 1310 to penetrate the word lines 1330, the string selection lines, and the ground selection line. The channel structure CH may include a data storage layer, a channel layer, and a buried insulation layer. The channel layer may be electrically connected to a first metal line 1350c and a second metal line 1360c in the bit line bonding region BLBA. For example, the second metal line 1360c may be a bit line, and may be connected to the channel structure CH through the first metal line 1350c. The bitline 1360c may extend in a first direction (e.g., a Y-axis direction) parallel to the upper surface of the second substrate 1310.

In some embodiments, as illustrated in a region 'A2,' the channel structure CH may include a lower channel LCH and an upper channel UCH, which are connected to each other. For example, the channel structure CH may be formed by a process of forming the lower channel LCH and a process of forming the upper channel UCH. The lower channel LCH may extend in the direction perpendicular to the upper surface of the second substrate 1310 to penetrate the common source line 1320 and lower word lines 1331 and 1332. The lower channel LCH may include a data storage layer, a channel layer, and a buried insulation layer, and may be connected to the upper channel UCH. The upper channel UCH may penetrate upper word lines 1333 to 1338. The upper channel UCH may include a data storage layer, a channel layer, and a buried insulation layer, and the channel layer of the upper channel UCH may be electrically connected to the first metal line 1350c and the second metal line 1360c. As a length of a channel increases, due to characteristics of manufacturing processes, it may be difficult to form a channel having a substantially uniform width. The non-volatile memory device 1500 according to the embodiments of the present inventive concept may include a channel having improved width uniformity by means of to the lower channel LCH and the upper channel UCH which are formed by the processes performed sequentially.

In the case in which the channel structure CH includes the lower channel LCH and the upper channel UCH as illustrated in the region `A2,' a word line located near to a boundary between the lower channel LCH and the upper channel UCH may be a dummy word line. For example, the word lines 1332 and 1333 adjacent to the boundary between the lower channel LCH and the upper channel UCH may be the dummy word lines. In this case, data may not be stored in memory cells connected to the dummy word line. Alternatively, the number of pages corresponding to the memory cells connected to the dummy word line may be less than the number of pages corresponding to the memory cells connected to a general word line. A level of a voltage applied to the dummy word line may be different from a level of a voltage applied to the general word line, and therefore, it is possible to reduce an influence of a non-uniform channel width between the lower and upper channels LCH and UCH on an operation of the memory device.

Meanwhile, the number of the lower word lines 1331 and 1332 penetrated by the lower channel LCH is less than the number of the upper word lines 1333 to 1338 penetrated by the upper channel UCH in the region 'A2' . However, embodiments of the present inventive concept are not limited thereto. In certain embodiments, the number of the lower word lines penetrated by the lower channel LCH may be equal to or more than the number of the upper word lines penetrated by the upper channel UCH. In addition, structural features and connection relation of the channel structure CH disposed in the second cell region CELL2 may be substantially the same as those of the channel structure CH disposed in the first cell region CELL1.

In the bit line bonding region BLBA, the first cell region CELL1 may be provided with a first through-electrode THV1, and the second cell region CELL2 may be provided with a second through-electrode THV2. As illustrated in FIG. 23, the first through-electrode THV1 may penetrate the common source line 1320 and the plurality of word lines 1330. However, embodiments of the present inventive concept are not limited thereto. In certain embodiments, the first through-electrode THV1 may further penetrate the second substrate 1310. The first through-electrode THV1 may include a conductive material. Alternatively, the first through-electrode THV1 may include a conductive material surrounded by an insulating material. The second through-electrode THV2 may have the same shape and structure as the first through-electrode THV1.

In some embodiments, the first through-electrode THV1 and the second through-electrode THV2 may be electrically connected to each other through a first through-metal pattern 1372d and a second through-metal pattern 1472d. The first through-metal pattern 1372d may be formed at a lower end of the first upper chip including the first cell region CELL1, and the second through-metal pattern 1472d may be formed at a top end of the second upper chip including the second cell region CELL2. The first through-electrode THV1 may be electrically connected to the first metal line 1350c and the second metal line 1360c. A lower via 1371d may be formed between the first through-electrode THV1 and the first through-metal pattern 1372d, and an upper via 1471d may be formed between the second through-electrode THV2 and the second through-metal pattern 1472d. The first through-metal pattern 1372d and the second through-metal pattern 1472d may be connected to each other by the bonding method.

In addition, in the bit line bonding region BLBA, an upper metal pattern 1252 may be formed in an uppermost metal layer of the peripheral circuit region PERI, and an upper metal pattern 1392 having the same shape as the upper metal pattern 1252 may be formed in an uppermost metal layer of the first cell region CELL1. The upper metal pattern 1392 of the first cell region CELL1 and the upper metal pattern 1252 of the peripheral circuit region PERI may be electrically connected to each other by the bonding method. In the bit line bonding region BLBA, the bit line 1360c may be electrically connected to a page buffer included in the peripheral circuit region PERI. For example, some of the circuit elements 1220c of the peripheral circuit region PERI may constitute the page buffer, and the bit line 1360c may be electrically connected to the circuit elements 1220c constituting the page buffer through an upper bonding metal pattern 1370c of the first cell region CELL1 and an upper bonding metal pattern 1270c of the peripheral circuit region PERI.

Referring continuously to FIG. 23, in the word line bonding region WLBA, the word lines 1330 of the first cell region CELL1 may extend in a second direction (e.g., an X-axis direction) parallel to the upper surface of the second substrate 1310, and may be connected to a plurality of cell contact plugs 1340 (1341 to 1347). First metal lines 1350b and second metal lines 1360b may be sequentially connected onto the cell contact plugs 1340 connected to the word lines 1330. In the word line bonding region WLBA, the cell contact plugs 1340 may be connected to the peripheral circuit region PERI through upper bonding metal patterns 1370b of the first cell region CELL1 and upper bonding metal patterns 1270b of the peripheral circuit region PERI.

The cell contact plugs 1340 may be electrically connected to a row decoder included in the peripheral circuit region PERI. For example, some of the circuit elements 1220b of the peripheral circuit region PERI may constitute the row decoder, and the cell contact plugs 1340 may be electrically connected to the circuit elements 1220b constituting the row decoder through the upper bonding metal patterns 1370b of the first cell region CELL1 and the upper bonding metal patterns 1270b of the peripheral circuit region PERI. In some embodiments, an operating voltage of the circuit elements 1220b constituting the row decoder may be different from an operating voltage of the circuit elements 1220c constituting the page buffer. For example, the operating voltage of the circuit elements 1220c constituting the page buffer may be greater than the operating voltage of the circuit elements 1220b constituting the row decoder.

Likewise, in the word line bonding region WLBA, the word lines 1430 of the second cell region CELL2 may extend in the second direction (e.g., the X-axis direction) parallel to the upper surface of the third substrate 1410, and may be connected to a plurality of cell contact plugs 1440 (1441 to 1447). The cell contact plugs 1440 may be connected to the peripheral circuit region PERI through an upper metal pattern of the second cell region CELL2, and lower and upper metal patterns and a cell contact plug 1348 of the first cell region CELL1.

In the word line bonding region WLBA, the upper bonding metal patterns 1370b may be formed in the first cell region CELL1, and the upper bonding metal patterns 1270b may be formed in the peripheral circuit region PERI. The upper bonding metal patterns 1370b of the first cell region CELL1 and the upper bonding metal patterns 1270b of the peripheral circuit region PERI may be electrically connected to each other by the bonding method. The upper bonding metal patterns 1370b and the upper bonding metal patterns 1270b may be formed of aluminum, copper, tungsten, and/or the like.

In the external pad bonding region PA, a lower metal pattern 1371e may be formed in a lower portion of the first cell region CELL1, and an upper metal pattern 1472a may be formed in an upper portion of the second cell region CELL2. The lower metal pattern 1371e of the first cell region CELL1 and the upper metal pattern 1472a of the second cell region CELL2 may be connected to each other by the bonding method in the external pad bonding region PA. Likewise, an upper metal pattern 1372a may be formed in an upper portion of the first cell region CELL1, and an upper metal pattern 1272a may be formed in an upper portion of the peripheral circuit region PERI. The upper metal pattern 1372a of the first cell region CELL1 and the upper metal pattern 1272a of the peripheral circuit region PERI may be connected to each other by the bonding method.

Common source line contact plugs 1380 and 1480 may be disposed in the external pad bonding region PA. The common source line contact plugs 1380 and 1480 may be formed of a conductive material such as a metal, a metal compound, doped polysilicon, and/or the like. The common source line contact plug 1380 of the first cell region CELL1 may be electrically connected to the common source line 1320, and the common source line contact plug 1480 of the second cell region CELL2 may be electrically connected to the common source line 1420. A first metal line 1350a and a second metal line 1360a may be sequentially stacked on the common source line contact plug 1380 of the first cell region CELL1, and a first metal line 1450a and a second metal line 1460a may be sequentially stacked on the common source line contact plug 1480 of the second cell region CELL2.

Input/output pads 1205, 1405 and 1406 may be disposed in the external pad bonding region PA. Referring to FIG. 23, a lower insulating layer 1201 may cover a lower surface of the first substrate 1210, and a first input/output pad 1205 may be formed on the lower insulating layer 1201. The first input/output pad 1205 may be connected to at least one of a plurality of the circuit elements 1220a disposed in the peripheral circuit region PERI through a first input/output contact plug 1203, and may be separated from the first substrate 1210 by the lower insulating layer 1201. In addition, a side insulating layer may be disposed between the first input/output contact plug 1203 and the first substrate 1210 to electrically isolate the first input/output contact plug 1203 from the first substrate 1210.

An upper insulating layer 1401 covering an upper surface of the third substrate 1410 may be formed on the third substrate 1410. A second input/output pad 1405 and/or a third input/output pad 1406 may be disposed on the upper insulating layer 1401. The second input/output pad 1405 may be connected to at least one of the plurality of circuit elements 1220a disposed in the peripheral circuit region PERI through second input/output contact plugs 1403 and 1303, and the third input/output pad 1406 may be connected to at least one of the plurality of circuit elements 1220a disposed in the peripheral circuit region PERI through third input/output contact plugs 1404 and 1304.

In some embodiments, the third substrate 1410 may not be disposed in a region in which the input/output contact plug is disposed. For example, as illustrated in a region 'B,' the third input/output contact plug 1404 may be separated from the third substrate 1410 in a direction parallel to the upper surface of the third substrate 1410, and may penetrate an interlayer insulating layer 1415 of the second cell region CELL2 so as to be connected to the third input/output pad 1406. In this case, the third input/output contact plug 1404 may be formed by at least one of various processes.

In some embodiments, as illustrated in a region 'B1,' the third input/output contact plug 1404 may extend in a third direction (e.g., the Z-axis direction), and a diameter of the third input/output contact plug 1404 may become progressively greater toward the upper insulating layer 1401. A diameter of the channel structure CH described in the region 'A1' may become progressively less toward the upper insulating layer 1401, but the diameter of the third input/output contact plug 1404 may become progressively greater toward the upper insulating layer 1401. For example, the third input/output contact plug 1404 may be formed after the second cell region CELL2 and the first cell region CELL1 are bonded to each other by the bonding method.

In certain embodiments, as illustrated in a region 'B2,' the third input/output contact plug 1404 may extend in the third direction (e.g., the Z-axis direction), and a diameter of the third input/output contact plug 1404 may become progressively less toward the upper insulating layer 1401. Like the channel structure CH, the diameter of the third input/output contact plug 1404 may become progressively less toward the upper insulating layer 1401. For example, the third input/output contact plug 1404 may be formed together with the cell contact plugs 1440 before the second cell region CELL2 and the first cell region CELL1 are bonded to each other.

In certain embodiments, the input/output contact plug may overlap with the third substrate 1410. For example, as illustrated in a region 'C,' the second input/output contact plug 1403 may penetrate the interlayer insulating layer 1415 of the second cell region CELL2 in the third direction (e.g., the Z-axis direction), and may be electrically connected to the second input/output pad 1405 through the third substrate 1410. In this case, a connection structure of the second input/output contact plug 1403 and the second input/output pad 1405 may be realized by various methods.

In some embodiments, as illustrated in a region 'C1,' an opening 1408 may be formed to penetrate the third substrate 1410, and the second input/output contact plug 1403 may be directly connected to the second input/output pad 1405 through the opening 1408 formed in the third substrate 1410. In this case, as illustrated in the region 'C1,' a diameter of the second input/output contact plug 1403 may become progressively greater toward the second input/output pad 1405. However, embodiments of the present inventive concept are not limited thereto, and in certain embodiments, the diameter of the second input/output contact plug 1403 may become progressively less toward the second input/output pad 1405.

In certain embodiments, as illustrated in a region 'C2,' an opening 1408 penetrating the third substrate 1410 may be formed, and a contact 1407 may be formed in the opening 1408. An end of the contact 1407 may be connected to the second input/output pad 1405, and the other end of the contact 1407 may be connected to the second input/output contact plug 1403. Thus, the second input/output contact plug 1403 may be electrically connected to the second input/output pad 1405 through the contact 1407 in the opening 1408. In this case, as illustrated in the region 'C2,' a diameter of the contact 1407 may become progressively greater toward the second input/output pad 1405, and a diameter of the second input/output contact plug 1403 may become progressively less toward the second input/output pad 1405. For example, the second input/output contact plug 1403 may be formed together with the cell contact plugs 1440 before the second cell region CELL2 and the first cell region CELL1 are bonded to each other, and the contact 1407 may be formed after the second cell region CELL2 and the first cell region CELL1 are bonded to each other.

In certain embodiments, as illustrated in a region 'C3,' a stopper 1409 may be further formed on a lower end of the opening 1408 of the third substrate 1410, as compared with the embodiments of the region 'C2'. The stopper 1409 may be a metal line formed on the same layer as the common source line 1420. However, embodiments of the present inventive concept are not limited thereto, and in certain embodiments, the stopper 1409 may be a metal line formed on the same layer as at least one of the word lines 1430. The second input/output contact plug 1403 may be electrically connected to the second input/output pad 1405 through the contact 1407 and the stopper 1409.

Like the second and third input/output contact plugs 1403 and 1404 of the second cell region CELL2, a diameter of each of the second and third input/output contact plugs 1303 and 1304 of the first cell region CELL1 may become progressively less toward the lower metal pattern 1371e or may become progressively greater toward the lower metal pattern 1371e.

Meanwhile, in some embodiments, a slit 1411 may be formed in the third substrate 1410. For example, the slit 1411 may be formed at a certain position of the external pad bonding region PA. For example, as illustrated in a region 'D,' the slit 1411 may be located between the second input/output pad 1405 and the cell contact plugs 1440 when viewed in a plan view. However, embodiments of the present inventive concept are not limited thereto, and in certain embodiments, the second input/output pad 1405 may be located between the slit 1411 and the cell contact plugs 1440 when viewed in a plan view.

In some embodiments, as illustrated in a region 'D1,' the slit 1411 may be formed to penetrate the third substrate 1410. For example, the slit 1411 may be used to prevent the third substrate 1410 from being finely cracked when the opening 1408 is formed. However, embodiments of the present inventive concept are not limited thereto, and in certain embodiments, the slit 1411 may be formed to have a depth ranging from about 60% to about 70% of a thickness of the third substrate 1410.

In certain embodiments, as illustrated in a region 'D2,' a conductive material 1412 may be formed in the slit 1411. For example, the conductive material 1412 may be used to discharge a leakage current occurring during driving of the circuit elements in the external pad bonding region PA to the outside. In this case, the conductive material 1412 may be connected to an external ground line.

In certain embodiments, as illustrated in a region 'D3,' an insulating material 1413 may be formed in the slit 1411. For example, the insulating material 1413 may be used to electrically isolate the second input/output pad 1405 and the second input/output contact plug 1403 disposed in the external pad bonding region PA from the word line bonding region WLBA. Since the insulating material 1413 is formed in the slit 1411, it is possible to prevent a voltage provided through the second input/output pad 1405 from affecting a metal layer disposed on the third substrate 1410 in the word line bonding region WLBA.

Meanwhile, in certain embodiments, the first to third input/output pads 1205, 1405 and 1406 may be selectively formed. For example, the non-volatile memory device 1500 may be realized to include only the first input/output pad 1205 disposed on the first substrate 1210, to include only the second input/output pad 1405 disposed on the third substrate 1410, or to include only the third input/output pad 1406 disposed on the upper insulating layer 1401.

An ESD diode according to an embodiment of the present inventive concept may be connected to at least one of the first to third input/output pads 1205, 1405, and 1406. For example, the first input/output pad 1205 may be a signal pad configured to output a signal to another external device or receive a signal therefrom. The ESD diode connected to the first input/output pad 1205 may be formed on the first substrate 1210, and include an N-type impurity region doped with N-type impurities and a P-type impurity region doped with P-type impurities.

For example, an ESD diode according to at least one of the embodiments described with reference to FIGS. 4 to 21 may be connected to the first input/output pad 1205. The ESD diode may be connected between the first input/output pad 1205 and a pad to which the power supply voltage is input. Each of an N-type impurity region and a P-type impurity region included in the ESD diode may be formed in a well region doped with P-type impurities or N-type impurities, and a lower surface of at least one of the N-type impurity region and the P-type impurity region contacting the well region may have an uneven structure. Accordingly, an ESD diode having high current drivability may be realized in a small area.

Meanwhile, on some embodiments, at least one of the second substrate 1310 of the first cell region CELL1 and the third substrate 1410 of the second cell region CELL2 may be used as a sacrificial substrate, and may be completely or partially removed before or after a bonding process. An additional layer may be stacked after the removal of the substrate. For example, the second substrate 1310 of the first cell region CELL1 may be removed before or after the bonding process of the peripheral circuit region PERI and the first cell region CELL1, and then, an insulating layer covering an upper surface of the common source line 1320 or a conductive layer for connection may be formed. Likewise, the third substrate 1410 of the second cell region CELL2 may be removed before or after the bonding process of the first cell region CELL1 and the second cell region CELL2, and then, the upper insulating layer 1401 covering an upper surface of the common source line 1420 or a conductive layer for connection may be formed.

According to an embodiment of the present inventive concept, in at least one of the impurity regions included in the ESD diode, a lower surface thereof contacting a well region may have an uneven structure. Accordingly, the degree of integration and performance of a semiconductor device may be improved by realizing an ESD diode having high current drivability with a small area. In addition, by reducing the area as well as the number of impurity regions included in one ESD diode, and therefore, reducing the number of metal lines providing an anode and a cathode of the ESD diode, an increase in capacitance of a pad due to the ESD diode can be minimized. Accordingly, it is possible to improve characteristics of a signal which is input/output through the pad.

While example embodiments have been shown and described above, it will be apparent to those skilled in the art that modifications and variations could be made without departing from the scope of the present inventive concept as defined by the appended claims.

## Claims

1. A semiconductor device, comprising:
a first power supply pad (103; 201) configured to receive a first power supply voltage (VDD);
a second power supply pad (104; 202) configured to receive a second power supply voltage (VSS), the second power supply voltage (VSS) having a level lower than a level of the first power supply voltage (VDD);
a signal pad (101; 102; 203) configured to exchange a signal; and
a first electrostatic discharge, ESD, diode (D1; 300) comprising a first impurity region (310; 310A) doped with impurities of a first conductivity type and connected to the first power supply pad (103; 201), and a second impurity region (320) doped with impurities of a second conductivity type different from the first conductivity type and connected to the signal pad (101; 102; 203),
wherein a lower surface of at least one of the first impurity region (310; 310A) and the second impurity region (320) has an uneven structure.

2. The semiconductor device of claim 1, wherein the first impurity region (310; 310A) and the second impurity region (320) are disposed in a first well region (303) formed on a substrate (301), and the first well region (303) is doped with impurities of the first conductivity type.

3. The semiconductor device of claim 2, wherein a doping concentration of the first impurity region (310; 3 10A) is greater than a doping concentration of the first well region (303).

4. The semiconductor device of claim 2 or 3, wherein the first well region (303) is a deep N-well region.

5. The semiconductor device of any one of claims 2 to 4, wherein at least some region of a side surface of the first impurity region (3 10A) contacting the first well region (303) has an uneven structure.

6. The semiconductor device of any one of claims 1 to 5, wherein the second impurity region (320) is surrounded by the first impurity region (310; 310A) in a plane parallel to an upper surface of a substrate (301), and an element isolation layer (305; 405) is disposed between the first impurity region (310; 3 10A) and the second impurity region (320) in the plane parallel to the upper surface of the substrate (301).

7. The semiconductor device of claim 6, wherein, in a direction (Z) perpendicular to the substrate (301), a depth of the element isolation layer (305; 405) is greater than a maximum depth of the first impurity region (310; 310A) and a maximum depth of the second impurity region (320).

8. The semiconductor device of any one of claims 1 to 7, wherein the second impurity region (320) is surrounded by the first impurity region (3 10A) in a plane parallel to a substrate (301), and at least some region of a side surface of the first impurity region (310A) contacting the second impurity region has an uneven structure.

9. The semiconductor device of any one of claims 1 to 8, further comprising:
a plurality of first metal wirings (330) extending in a first direction (X) in a plane parallel to an upper surface of a substrate (301), disposed on an upper surface of the first impurity region (310; 310A), and electrically connected to the first impurity region (310; 310A); and
at least one second metal wiring (340) extending in the first direction (X), disposed on an upper surface of the second impurity region (320), and electrically connected to the second impurity region (320).

10. The semiconductor device of claim 9, wherein the quantity of the first metal wirings (330) is greater than a quantity of the second metal wirings (340).

11. The semiconductor device of claim 9 or 10, wherein, in a second direction (Y) in a plane parallel to the upper surface of the substrate (301) and intersecting the first direction (X), the second metal wiring (340) is disposed between the first metal wirings (330).

12. The semiconductor device of any one of claims 1 to 11, wherein ESD diode has a single each of a number of the first impurity region (310; 3 10A) and a single a number of the second first impurity region (310; 3 10A) comprised in the first ESD diode is 1.

13. The semiconductor device of any one of claims 1 to 12, further comprising:
a second ESD diode (D2; 400) comprising a third impurity region (410) doped with impurities of the first conductivity type and connected to the signal pad (101; 102; 203), and a fourth impurity region (420; 420A) doped with impurities of the second conductivity type and connected to the second power supply pad (104; 202).

14. The semiconductor device of claim 13, wherein a lower surface of the third impurity region (410) has an uneven structure.

15. The semiconductor device of claim 13 or 14, wherein the third impurity region (410) and the fourth impurity region are disposed in a second well region (403) formed on a substrate (301), and the second well region (403) is doped with impurities of the second conductivity type.
